# EUROPEAN PATENT APPLICATION

(11) **EP 1 381 078 A1**
(43) Date of publication of application: **14.01.2004**
(21) Application number: 02705101.0
(22) Date of filing: 13.03.2002
(51) Int. Cl.: H01L 21/31

(54) **ULTRAVIOLET RAY ASSISTED PROCESSING DEVICE FOR SEMICONDUCTOR PROCESSING**

(30) Priority: 06.04.2001 JP 2001108358
(71) Applicant: TOKYO ELECTRON LIMITED, Minato-ku, Tokyo 107-8481 (JP)
(72) Inventor: SHAO, Shou-Qian, Winchester, MA 01890 (US); LI, Yicheng, c/o Tokyo Electron AT Limited, Tsukui-gun, Kanaga wa 220-0101 (JP)
(74) Representative: Grosse, Rainer, Dipl.-Ing.
(86) International application number: PCT/JP2002/002326
(87) International publication number: WO 2002/084726

(57) **Abstract**

An ultraviolet-ray-assisted processing apparatus (10) for a semiconductor process includes a window disposed in a wall defining the process chamber (12) and to face a worktable (11), and configured to transmit ultraviolet rays. A light source (15) is disposed outside the process chamber (12) to face the window (20), and configured to emit ultraviolet rays. A supply system configured to supply a process gas in the process chamber (12) includes a head space (21) formed in the window (20) and which the process gas passes through, and a plurality of discharge holes (22) for discharging the process gas.

## Description

### Technical Field

The present invention relates to an ultraviolet-ray-assisted processing apparatus for performing a semiconductor process, such as film-deposition, e.g., CVD (Chemical Vapor Deposition), oxidation, diffusion, reformation, annealing, or etching. The term "semiconductor process" used herein includes various kinds of processes which are performed to manufacture a semiconductor device or a structure having wiring layers, electrodes, and the like to be connected to a semiconductor device, on a target substrate, such as a semiconductor wafer or an LCD substrate, by forming semiconductor layers, insulating layers, and conductive layers in predetermined patterns on the target substrate.

### Background Art

In the process of manufacturing semiconductor devices, various semiconductor processing apparatuses are used for performing processes, such as film-deposition, oxidation, diffusion, reformation, annealing, and etching, on a target substrate, such as a semiconductor wafer. A single-substrate processing apparatus for processing wafers one by one is known as a processing apparatus of this kind. In general, a single-substrate processing apparatus has an airtight process chamber and a worktable for placing a target substrate thereon within the process chamber.

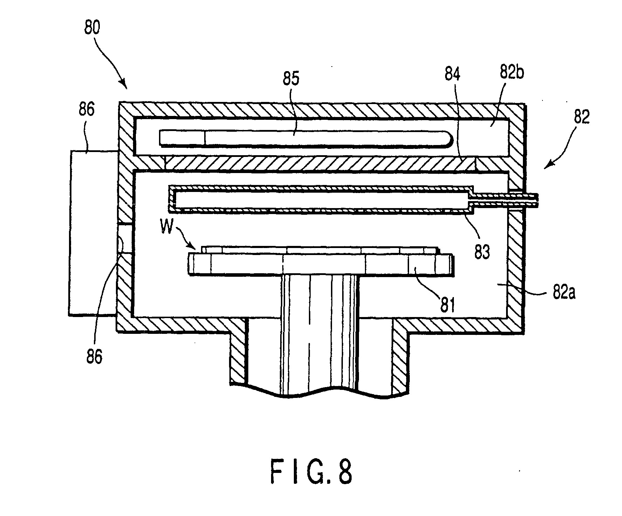

FIG. 8 is a sectional view schematically showing a conventional ultraviolet-ray-assisted processing apparatus (film-formation apparatus) of the single-substrate type.

This film-formation apparatus 80 has a process container 82, which is divided into a process chamber 82a and an auxiliary chamber 82b by an ultraviolet ray transmission window 84. Within the process chamber 82a, a worktable 81 is disposed for placing thereon a semiconductor wafer W as a target substrate. The worktable 81 is provided with a heater (not shown) built therein. Within the process chamber 82a, a showerhead 83 made of quartz glass is disposed to face the worktable 81. The showerhead 83 is connected to a - process gas source (not shown) for supplying a process gas into the process chamber 82a. A sidewall of the process chamber 82a is provided with a wafer port 86 formed therein for loading/unloading the wafer W. The wafer port 86 is opened/closed by a gate valve 87.

On the other hand, within the auxiliary chamber 82b, an ultraviolet lamp 85 is disposed to face the window 84. Ultraviolet rays emitted from the ultraviolet lamp 85 are transmitted through the window 84 and showerhead 83, and radiated onto a process gas within the process chamber 82a. With the energy of ultraviolet rays and the thermal energy of the heater built in the worktable 81, the process gas is caused to decompose and generate active species. By the agency of the active species thus generated, a film is formed on the wafer W.

In the film-formation apparatus 80, the ultraviolet lamp 85 faces the wafer W with the showerhead 83 interposed therebetween. Accordingly, the distance between the ultraviolet lamp 85 and wafer W is inevitably large, thereby decreasing the intensity of the ultraviolet rays radiated onto the process gas. As a consequence, a problem arises in that the efficiency of the film-formation process decreases. Such a problem similarly occurs in other semiconductor processes, such as oxidation, diffusion, reformation, annealing, and etching.

Furthermore, in recent years, it is required in manufacturing semiconductor devices that wafer diameters be larger, circuits be more highly integrated, and miniaturization of pattern dimensions further proceed (scale down in design rules). Then, there is a case where a process gas needs to be irradiated with ultraviolet rays, while a target substrate, such as a wafer, should be less influenced by the ultraviolet rays, depending on the process content.

### Disclosure of Invention

Accordingly, an object of the present invention is to provide an ultraviolet-ray-assisted processing apparatus for a semiconductor process that can perform the process with a high efficiency.

Another object of the present invention is to provide an ultraviolet-ray-assisted processing apparatus for a semiconductor process that allows a process gas to be irradiated with ultraviolet rays, while the influence of the ultraviolet rays on a target substrate can be reduced as far as possible.

According to a first aspect of the present invention, there is provided an ultraviolet-ray-assisted processing apparatus for a semiconductor process, comprising:
a process chamber configured to accommodate a target substrate;
a worktable disposed within the process chamber and configured to support the target substrate;
a heater configured to heat the target substrate through the worktable;
a window disposed in a wall defining the process chamber and to face the worktable, and configured to transmit ultraviolet rays;
a light source disposed outside the process chamber to face the window, and configured to emit ultraviolet rays;
a gas exhaust system configured to exhaust an interior of the process chamber; and
a supply system configured to supply a process gas into the process chamber, wherein the supply system includes a head space formed in the window and which the process gas passes through, and a plurality of discharge holes formed in a surface of the window facing the worktable and communicating with the head space to discharge the process gas.

The head space may form a gas passage having a width of 1 to 10 mm on a plane facing the light source. Instead of this, the head space may form a gas reservoir having an contour larger than the target substrate.

According to a second aspect of the present invention, there is provided an ultraviolet-ray-assisted processing apparatus for a semiconductor process, comprising:
a process chamber configured to accommodate a target substrate;
a worktable disposed within the process chamber and configured to support the target substrate;
a heater configured to heat the target substrate through the worktable;
a window disposed in a wall defining the process chamber and to face the worktable, and configured to transmit ultraviolet rays;
a light source disposed outside the process chamber to face the window, and configured to emit ultraviolet rays;
a gas exhaust system configured to exhaust an interior of the process chamber; and
a supply system configured to supply first and second process gases into the process chamber, wherein the supply system includes first and second head spaces formed in the window and which the first and second process gases respectively pass through, and a plurality of first and second discharge holes formed in a surface of the window facing the worktable and respectively communicating with the first and second head spaces to discharge the first and second process gases.

### Brief Description of Drawings

FIG. 1 is a sectional view schematically showing an ultraviolet-ray-assisted processing apparatus (film-formation apparatus) for a semiconductor process according to an embodiment of the present invention;
FIG. 2 is an enlarged sectional view showing an ultraviolet ray transmission window used in the apparatus shown in FIG. 1;
FIG. 3 is a sectional plan view of the transmission window taken along line III-III in FIG. 2;
FIG. 4 is an enlarged sectional view showing an ultraviolet ray transmission window used in an ultraviolet-ray-assisted processing apparatus for a semiconductor process according to another embodiment of the present invention;
FIG. 5 is a sectional plan view of the transmission window taken along line V-V in FIG. 4;
FIG. 6 is a sectional view schematically showing an ultraviolet-ray-assisted processing apparatus (CVD apparatus) for a semiconductor process according to still another embodiment of the present invention;
FIG. 7 is an enlarged sectional view showing an ultraviolet ray transmission window used in the apparatus shown in FIG. 6; and
FIG. 8 is a sectional view schematically showing a conventional ultraviolet-ray-assisted processing apparatus (film-formation apparatus) of the single-substrate type.

### Best Mode for Carrying Out the Invention

Embodiments of the present invention will be described hereinafter with reference to the accompanying drawings. In the following description, the constituent elements having substantially the same function and arrangement are denoted by the same reference numerals, and a repetitive description will be made only when necessary.

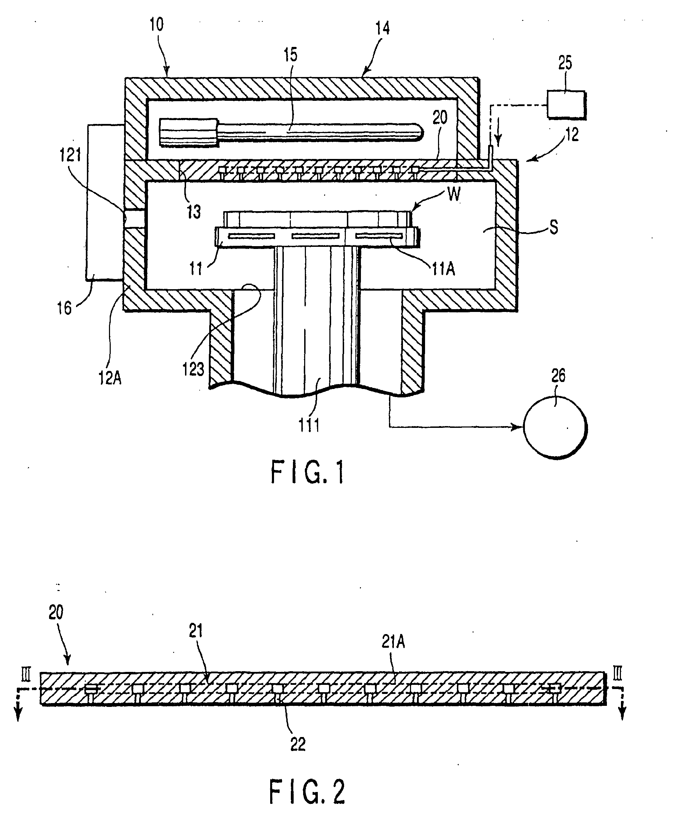

FIG. 1 is a sectional view schematically showing an ultraviolet-ray-assisted processing apparatus (film-formation apparatus) for a semiconductor process according to an embodiment of the present invention. The sectional view of FIG. 1 shows a vertical section relative to a target substrate (semiconductor wafer) placed within a process chamber.

The film-formation apparatus 10 has a process chamber 12, which is almost cylindrical as a whole, for accommodating a semiconductor wafer W as a target substrate. An opening 13 is formed at the center of the ceiling plate of the process chamber 12, and is airtightly closed by a window 20 that transmits ultraviolet rays. An auxiliary chamber 14 is disposed on the process chamber 12 and separated by the transmission window 20 from the process chamber 12.

A sidewall 12A of the process chamber 12 is provided with a wafer port 121 formed therein for loading/unloading the wafer W. The wafer port 121 is opened/closed by a gate valve 16 disposed outside the sidewall 12A. An opening 123 is formed at the center of the bottom plate of the process chamber 12, and is connected through a gas exhaust line to a gas exhaust section 26 including a vacuum pump or the like. The gas exhaust section 26 is used to vacuum-exhaust the interior of the process chamber 12 and set it at a predetermined vacuum level.

Within the process chamber 12, a worktable 11 is dispased to face the ultraviolet ray transmission window 20, for placing a wafer W thereon.
The worktable 11 is coaxially supported at the top of a hollow cylindrical support portion 111. The support portion 111 extends downward through the opening 123 formed in the bottom of the process chamber 12. The bottom of the support portion 111 is connected to a rotary mechanism (not shown) for rotating the worktable 11 and an elevator mechanism (not shown) for moving the worktable 11 up and down.

The worktable 11 is provided with a heater 11A built therein and made of, e.g., a nitride-based ceramic coated with SiC. The heater 11A is connected to a power supply section through a feed line extending within the support portion 111. The heater 11A is used to uniformly heat a wafer W at a predetermined temperature through a mount face of the worktable 11.

Within the auxiliary chamber 14, a light source 15 of ultraviolet rays is disposed to face the ultraviolet ray transmission window 20. The inside of the auxiliary chamber 14 is filled with an inactive gas, such as nitrogen gas. The light source 15 is formed of a low pressure mercury lamp, high pressure mercury lamp, excimer laser light source, or the like. The intensity and wavelength of light emitted from the light source 15 are adjusted in accordance with the process manner and process gas. The light source 15 may be formed of a plurality of rod-like lamps laterally juxtaposed entirely over the transmission window 20, or a lamp of a line light source type or point light source type used in combination with a mirror.

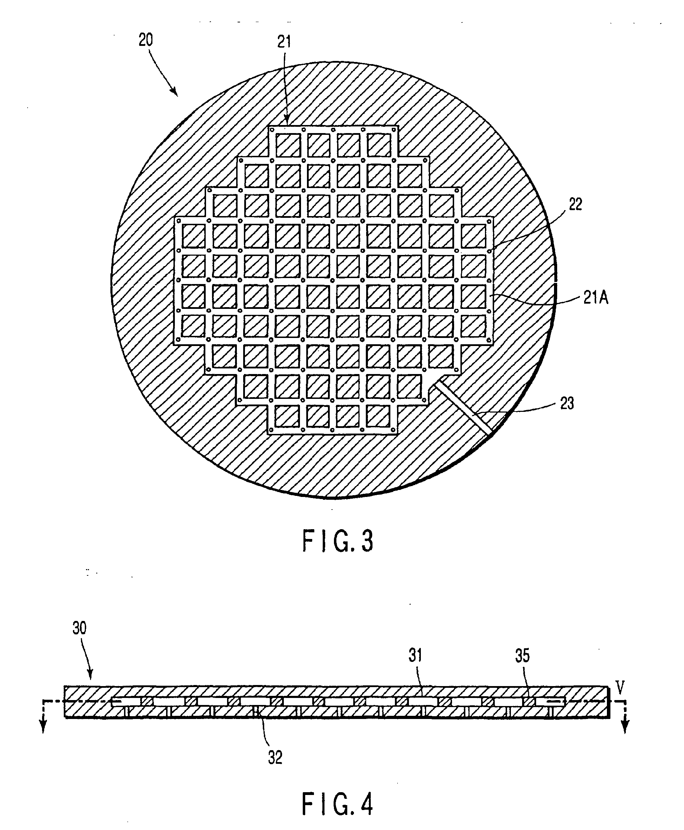

FIG. 2 is an enlarged sectional view showing the ultraviolet ray transmission window 20. FIG. 3 is a sectional plan view of the transmission window 20 taken along line III-III in FIG. 2.

The transmission window 20 consists essentially of a material selected from the group consisting of quartz, silicon oxide, sapphire, and calcium fluoride (CaF₂). The transmission window 20 is formed of a circular plate larger than the diameter of the wafer W, and disposed coaxially with the worktable 11 and the wafer W placed thereon. The transmission window 20 is provided with a head space (gas passage) 21 formed therein, for supplying a process gas into the process chamber 12. A plurality of discharge holes 22 for discharging the process gas are formed in the surface of the transmission window 20 that faces the worktable 11, and communicate with the head space 21.

More specifically, as shown in FIG. 3, the head space 21 is formed of a gas passage 21 that forms a lattice-like pattern entirely over a region facing the wafer W and having a contour larger than the wafer W. The lattice of the gas passage 21 consists of a plurality of passage portions 21A, which extend equidistantly in vertical and horizontal directions on a plane parallel with the surface of transmission window 20, and communicate with each other at intersections. Each of the passage portions 21A is formed to have a width of 1 to 10 mm, and preferably 3 to 6 mm, on a plane facing the light source 15.

The process gas discharge holes 22 are formed at the intersections of the passage portions 21A (the corners of the lattice pattern formed by the gas passage 21). The discharge holes 22 are opened at one end to the inner space of the process chamber 12 to allow the gas passage 21 to communicate with the inner space of the process chamber 12. The discharge holes 22 are uniformly distributed on the bottom of the transmission window 20 (the lower surface in FIG. 2), at least in an area corresponding to the contour of the wafer W.

The gas passage (head space) 21 communicates with a gas introduction passage 23, which is opened at one end to the peripheral side of the transmission window 20. The gas introduction passage 23 is connected to a process gas supply section 25 through a supply line. A process gas is suitably selected in accordance with the type of a film to be formed, such that, for example, oxygen gas, ozone gas, or the like is used in the case of film-formation process of an oxide film.

For example, the transmission window 20 may be formed of two circular plate components made of the material of the transmission window 20 and laminated one on the other. In this case, the gas passage 21 can be obtained by forming grooves in advance in the surface to be bonded of one of the components. The discharge holes 22 can be also obtained by forming holes in advance in the component to be located on the lower side. The grooves and holes may be formed at the same time the window is formed by cutting the material of the window or casting the material of the window with a mold. Welding may be used to bond the two components.

Next, an explanation will be given of a process in the film-formation apparatus 10 described above.

A wafer W is first transferred into the process chamber 12 through the loading/unloading port 121, and placed on the worktable 11, by a transfer mechanism (not shown). The wafer W is heated by the heater 11A to a predetermined temperature, and the interior of the process chamber 12 is set at a pressure-reduced state by the gas exhaust section 26. Then, while the process chamber 12 is kept exhausted, a process gas of e.g., ozone gas is supplied into the process chamber 12. At this time, the process gas is supplied at a controlled flow rate, from the supply section 25 through the gas introduction passage 23 into the gas passage (head space) 21 within the transmission window 20. Then, the process gas flows entirely in the gas passage 21, and is uniformly supplied from the gas discharge holes 22 into the process chamber 12.

On the other hand, the light source 15 of, e.g., an ultraviolet lamp is turned on to emit ultraviolet rays. Ultraviolet rays emitted from the light source 15 are transmitted through the transmission window 20, and radiated onto the process gas (ozone gas) within the process chamber 12. With the energy of ultraviolet rays and the thermal energy of the heater 11A built in the worktable 11, the process gas is caused to decompose and generate active species. By the agency of the active species thus generated, the wafer W is oxidized, so that an oxide film (for example, a silicon oxide film on a silicon wafer) is formed.

In the film-formation apparatus 10, a process gas is supplied into the process chamber 12 through the gas passage 21 and discharge holes 22 formed in the transmission window 20. Consequently, the process gas is uniformly supplied toward a wafer W. Since the process gas flows in the transmission window 20, the transmission window 20 is effectively prevented from being overheated and cracked.

Since no gas introducing means, such as a conventional showerhead, is required to be additionally disposed within the process chamber 12, the distance between the light source 15 and wafer W can be set very small. In addition, the area of the gas passage 21 is small, and ultraviolet rays are mainly transmitted through the material of the transmission window 20. This allows the ultraviolet rays to act on the process gas at a sufficiently high intensity within the process chamber, thereby generating active species with a high efficiency near the surface of a wafer W. As a consequence, a film-formation process on the wafer W can be performed with a high efficiency.

A processing apparatus having the structure shown in FIG. 1 may be used to perform a surface reformation process (annealing process) on a wafer W. In this case, a wafer W with a metal oxide film formed thereon is placed on a worktable 11 within a process chamber 12. Then, the wafer W is heated to a predetermined temperature, while the process chamber 12 is set at a pressure-reduced state. Then, a process gas of, e.g., ozone gas is supplied into the process chamber 12 through a gas passage 21 within a transmission window 20. On the other hand, a light source 15 is turned on to excite the ozone gas by ultraviolet rays within the process chamber 12, thereby generating a large amount of active species. By the agency of the active species, the metal oxide film on the surface of the wafer W is oxidized, so that the metal oxide film is reformed.

In place of the ultraviolet source 15, a halogen lamp may be used as heating means. In this case, the halogen lamp heats a wafer W to a predetermined temperature. A process gas thermally decomposed on the surface of the wafer W, and generates active species, with which a film-formation process or surface reformation process is performed on the wafer W. Also in this case, the distance between the halogen lamp and wafer W can be set very small. As a consequence, the wafer W is efficiently heated, and a predetermined process can be performed with a high efficiency.

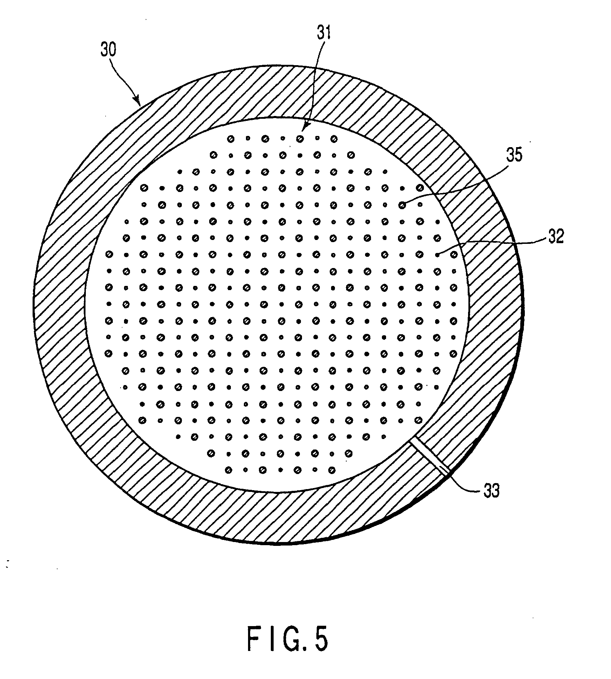

FIG. 4 is an enlarged sectional view showing an ultraviolet ray transmission window used in an ultraviolet-ray-assisted processing apparatus for a semiconductor process according to another embodiment of the present invention. FIG. 5 is a sectional plan view of the transmission window taken along line V-V in FIG. 4. The structure of the apparatus according to this embodiment may be the same as that of the apparatus shown in FIG. 1 except for an ultraviolet ray transmission window 30. Accordingly, the following explanation will be made with reference also to FIG. 1.

The transmission window 30 consists essentially of a material selected from the group consisting of quartz, silicon oxide, sapphire, and calcium fluoride (CaF₂). The transmission window 30 is formed of a circular plate larger than the diameter of a wafer W, and disposed coaxially with a worktable 11 and the wafer W placed thereon. The transmission window 30 is provided with a head space (gas passage) 31 formed therein, for supplying a process gas into a process chamber 12. A plurality of discharge holes 32 for discharging the process gas are formed in the surface of the transmission window 30 that faces the worktable 11, and communicate with the head space 31.

More specifically, as shown in FIG. 5, the head space 31 is formed of a gas reservoir 31 facing the wafer W and having a contour larger than the wafer W. The gas reservoir 31 is disposed coaxially with the worktable 11 and the wafer W placed thereon. A number of pin-like support members 35 stand between the top plate and bottom plate of the gas reservoir 31 to provide the transmission window 30 with a sufficient strength. The ratio of the total planar area of the support members 35 relative to the planar area of the gas reservoir 3 is small, such as 5 to 30%, and preferably 5 to 15%.

The support members 35 and process gas discharge holes 32 are alternatively disposed along hypothetical straight lines that form a grid pattern. The discharge holes 32 are opened at one end to the inner space of the process chamber 12 to allow the gas reservoir 31 to communicate with the inner space of the process chamber 12. The discharge holes 32 are uniformly distributed on the bottom of the transmission window 30 (the lower surface in FIG. 4), at least in an area corresponding to the contour of the wafer W.

The gas passage (head space) 31 communicates with a gas introduction passage 33, which is opened at one end to the peripheral side of the transmission window 30. The gas introduction passage 33 is connected to a process gas supply section 25 through a supply line.

For example, the transmission window 30 may be formed of two circular plate components made of the material of the transmission window 30 and laminated one on the other. In this case, the gas reservoir 31 can be obtained by forming a recess in advance in the surface to be bonded of one of the components. The support members 35 can be also obtained by disposing projections in advance on the surface to be bonded of one of the components. The discharge holes 32 can be also obtained by forming holes in advance in the component to be located on the lower side. The recess and holes may be formed at the same time the window is formed by cutting the material of the window or casting the material of the window with a mold. The projections to be used as support members 35 may be independently prepared and welded to the circular plate components.

In the film-formation apparatus according to this embodiment, a gas layer of a process gas is formed in the gas reservoir 31. The process gas is irradiated with ultraviolet rays from the light source 15 within the gas reservoir 31, and is activated by the energy of the ultraviolet rays within gas reservoir 31. The process gas thus activated is supplied into the process chamber 12 through the discharge holes 32, thereby performing the process on a wafer W.

Consequently, the process gas is uniformly supplied toward the wafer W. Since the process gas flows in the transmission window 30, the transmission window 30 is effectively prevented from being overheated and cracked. Since no gas introducing means, such as a conventional showerhead, is required to be additionally disposed within the process chamber 12, the process chamber 12 can be compact.

Since ultraviolet rays emitted from the light source 15 are absorbed by the process gas layer within the gas reservoir 31, the ultraviolet rays hardly directly reaching the wafer W. Thus, it is possible to realize a state where the wafer is substantially not irradiated with ultraviolet rays from the light source 15, by setting the amount of process gas within the gas reservoir 31, light radiation intensity from the light source 15, or the like. Therefore, a remarkably effective process can be performed for a case where the process gas needs to be irradiated with ultraviolet rays, while the wafer W should be less influenced by the ultraviolet rays. For example, this is a case where a light source of ultraviolet rays with a high energy has to be used in processing a wafer with a greatly minimized design rule.

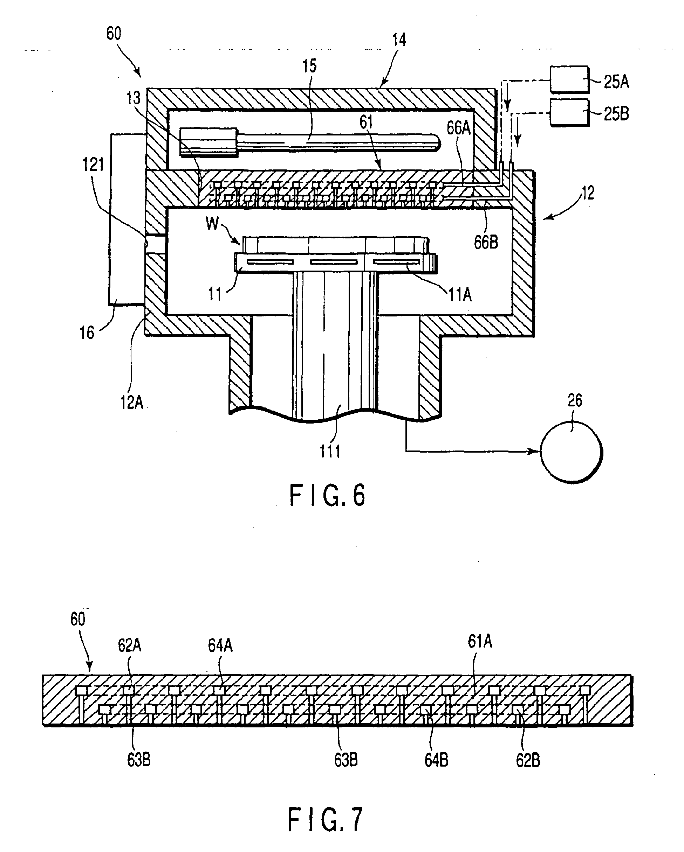

FIG. 6 is a sectional view schematically showing an ultraviolet-ray-assisted processing apparatus (CVD apparatus) for a semiconductor process according to still another embodiment of the present invention. FIG. 7 is an enlarged sectional view showing an ultraviolet ray transmission window used in the apparatus shown in FIG. 6. The apparatus shown in FIGS. 6 and 7 may be the same as that of the apparatus shown in FIG. 1 except for the ultraviolet ray transmission window and process gas supply system.

The transmission window 61 of this CVD apparatus 60 also consists essentially of a material selected from the group consisting of quartz, silicon oxide, sapphire, and calcium fluoride (CaF₂). The transmission window 61 is formed of a circular plate larger than the diameter of a wafer W, and disposed coaxially with a worktable 11 and the wafer W placed thereon. The transmission window 61 is provided with first and second head spaces (first and second gas passages) 62A and 62B formed therein, for supplying process gases into a process chamber 12. A plurality of first and second discharge holes 63A and 63B for discharging the process gases are formed in the surface of the transmission window 61 that faces the worktable 11, and communicate with the first and second head spaces 62A and 62B, respectively.

More specifically, the first and second head spaces 62A and 62B are stacked in the thickness direction of the transmission window 61 with a dividing plate 61A interposed therebetween. The first and second head spaces 62A and 62B are formed of first and second gas passages 62A and 62B that respectively form lattice patterns entirely over a region facing the wafer W and having a contour larger than the wafer W. Each of the lattice patterns of the first and second gas passages 62A and 62B is almost the same as that shown in FIG. 3. Each of the lattices of the first and second gas passages 62A and 62B consists of a plurality of passage portions 64A or 64B, which extend equidistantly in vertical and horizontal directions on a plane parallel with the surface of transmission window 61, and communicate with each other at intersections. Each of the passage portions 64A and 64B is formed to have a width of 1 to 10 mm, and preferably 3 to 6 mm, on a plane facing the light source 15.

The first and second process gas discharge holes 63A and 63B are formed at the intersections of the passage portions 64A and 64B (the corners of the grid patterns formed by the first and second gas passages 62A and 62B). The first and second discharge holes 63A and 63B are opened at one end to the inner space of the process chamber 12 to allow the first and second gas passages 62A and 62B to communicate with the inner space of the process chamber 12. The first and second discharge holes 63A and 63B are uniformly distributed on the bottom of the transmission window 61 (the lower surface in FIG. 7), at least in an area corresponding to the contour of the wafer W. The first discharge holes 63A are disposed alternately with the second discharge holes 63B (i.e., they are staggered) in radial directions of the transmission window 61.

The first and second gas passages (first and second head spaces) 62A and 62B communicate respectively with first and second gas introduction passages 66A and 66B, which are opened at one end to the peripheral side of the transmission window 61. The first and second gas introduction passages 66A and 66B are connected to first and second process gas supply sections 25A and 25B through supply lines. First and second process gases are suitably selected in accordance with the type of a film to be formed, such that, for example, an organic metal gas and oxygen are used as the first and second process gases in the case of forming a metal oxide film by CVD.

For example, the transmission window 61 may be formed of three or more circular plate components made of the material of the transmission window 61 and laminated one on the other. In this case, each of the first and second gas passages 62A and 62B can be obtained by forming grooves in advance in the surface to be bonded of one of the components. The first and second discharge holes 63A and 63B can be also obtained by forming holes in advance in the dividing plate 61A and the component to be located on the lower side. The grooves and holes may be formed at the same time the window is formed by cutting the material of the window or casting the material of the window with a mold.

In the film-formation apparatus 60 according to this embodiment, first and second process gases are supplied at controlled flow rates, from the first and second supply sections 25A and 25B through the first and second gas introduction passages 66A and 66B into the first and second gas passages (first and second head spaces) 62A and 62B within the transmission window 61. Then, the processes gases flow entirely in the first and second gas passages 62A and 62B, respectively, and are uniformly supplied from the first and second discharge holes 63A and 63B into the process chamber 12. The first and second process gases thus delivered respectively from the first and second discharge holes 63A and 63B are mixed within the process space, i.e., in so called a post-mixture manner.

On the other hand, ultraviolet rays emitted from the light source 15 are transmitted through the transmission window 61, and radiated onto the first and second process gases within the process chamber 12. With the energy of ultraviolet rays and the thermal energy of a heater 11A built in the worktable 11, the process gases are caused to decompose and generate active species. By a reaction of the active species thus generated, a CVD film, such as a metal oxide film, is formed on the wafer W.

In the film-formation apparatus 60, process gases are supplied into the process chamber 12 through the first and second gas passages 62A and 62B and first and second discharge holes 63A and 63B formed in the transmission window 61. Consequently, the process gases are uniformly supplied toward a wafer W. Since the process gases flow in the transmission window 61, the transmission window 61 is effectively prevented from being overheated and cracked.

Since no gas introducing means, such as a conventional showerhead, is required to be additionally disposed within the process chamber 12, the distance between the light source 15 and wafer W can be set very small. In addition, the areas of the first and second gas passages 62A and 62B are small, and ultraviolet rays are mainly transmitted through the material of the transmission window 61. This allows the ultraviolet rays to act on the process gases at a sufficiently high intensity within the process chamber, thereby generating active species with a high efficiency near the surface of a water W. As a consequence, a film-formation process on the wafer W can be performed with a high efficiency.

Furthermore, first and second gases of different kinds respectively flow through the first and second gas passages 62A and 62B independent of each other, and thus the first and second gas process gases do not react with each other within the transmission window 61. Accordingly, the transmission window 61 reliably prevents any reaction product from being generated therein, and thus prevents the process efficiency from lowering due to the reaction product. Since the first and second gas passages 62A and 62B are formed independently of each other, freedom of choice of the first and second process gases becomes higher, thereby allowing the apparatus to be set to perform film-formation processes of various kinds.

### <Experiment example 1>

A simulation experiment of a film-formation process was performed, using a film-formation apparatus (10) having a structure shown in FIG. 1 with a transmission window (20) shown in FIGS. 2 and 3 applied thereto. In this film-formation process, a gate oxide film having a thickness of 0.8 to 1.5 nm was formed on a wafer having a diameter of 200 mm, under the following conditions.

### [Conditions of transmission window (20)]

Transmission window thichness: 15 mm,
Transmission window diameter: 343 mm,
Sectional area of passage portions (21A): 2 mm²,
Number of gas discharge holes (22): 97,
Total area of light transmission portions divided by passage portions (21A): 5 × 10⁴ mm², and
Transmissivity relative to ultraviolet rays from light source (15): 80%.

### [Process conditions]

Process gas: oxygen gas,
Gas flow rate: 1 slm,
Gas pressure: 670 Pa (5 Torr),
Purge gas: nitrogen gas,
Wafer heating temperature: 450°C,
Light source: low pressure mercury lamp, and
Lamp radiation intensity: 50 mw/cm².

As a result, it was confirmed that a process time necessary for forming a predetermined silicon oxide film was shortened and the actual process efficiency improved by about 10 to 30%, as compared to a conventional processing apparatus.

### <Experiment example 2>

A simulation experiment of a surface reformation process was performed, using an annealing apparatus (10) having a structure shown in FIG. 1 with a transmission window (30) shown in FIGS. 4 and 5 applied thereto. This surface reformation process was performed on a metal oxide film (for example, tantalum oxide (Ta2O5) film) having a thickness of 8 nm that was disposed on the surface of a wafer having a diameter of 200 mm, under the following conditions.

### [Conditions of transmission window (30)]

Transmission window thickness: 20 mm,
Transmission window diameter: 343 mm,
Sectional area of gas reservoir (31): 5.7 × 10⁴ mm²,
Capacity of gas reservoir (31) : 2.86 × 10⁵ mm³, and
Number of gas discharge holes (32): 173.

### [Process conditions]

Process gas: ozone gas,
Gas flow rate: 10 slm,
Gas pressure: 4 kPa (30 Torr),
Wafer heating temperature: 500°C,
Light source: low pressure mercury lamp, and
Lamp radiation intensity: 50 mW/cm².

As a result, it was confirmed that a process time necessary for obtaining a predetermined film property was shortened and the actual process efficiency improved by about 10 to 30%, as compared to a conventional processing apparatus.

It should be noted that the embodiments described above may be modified variously, as follows.

Conditions, such as the thickness and size of the transmission window, the sectional area of the passage portions, the capacity of the process gas head space, and the number of gas introduction passages, may be suitably changed in accordance with a process to be performed. The number and distribution of the gas discharge holes in the transmission window are also not limited to specific ones. In this respect, these are preferably set to uniformly supply a process gas toward a target substrate.

For example, a film to be formed may be a silicon film, silicon oxynitride film, or metal oxide film, such as tantalum oxide film, titanium oxide film, zirconium oxide film, barium oxide film, or strontium oxide film. The type of a process gas is suitably changed in accordance with a process to be performed.

As a system of heating a target substrate, a lamp heating system using, e.g., a halogen lamp may be employed in place of a resistance heating system using a ceramic heater. In this case, a thin plate worktable is used and the halogen lamp is disposed below the worktable.

In the embodiments described above, an oxidation film-formation apparatus, annealing apparatus, and CVD apparatus are shown as examples. Alternatively, the present invention may be applied to another semiconductor process apparatus, such as a diffusion apparatus, etching apparatus, ashing apparatus, or sputtering apparatus. A process gas to be used is selectively changed in accordance with a process to be performed. Furthermore, the present invention may be applied to a target substrate other than a semiconductor wafer, such as an LCD substrate or glass substrate.

The present invention is not limited to the embodiments described above, but can be practiced in various manners without departing from the spirit and scope of the invention. The features of the embodiments described above can be arbitrarily combined with each other in practice, thereby obtaining combined effects.

## Claims

1. An ultraviolet-ray-assisted processing apparatus for a semiconductor process, comprising:
a process chamber configured to accommodate a target substrate;
a worktable disposed within the process chamber and configured to support the target substrate;
a heater configured to heat the target substrate through the worktable;
a window disposed in a wall defining the process chamber and to face the worktable, and configured to transmit ultraviolet rays;
a light source disposed outside the process chamber to face the window, and configured to emit ultraviolet rays;
a gas exhaust system configured to exhaust an interior of the process chamber; and
a supply system configured to supply a process gas into the process chamber, wherein the supply system includes a head space formed in the window and which the process gas passes through, and a plurality of discharge holes formed in a surface of the window facing the worktable and communicating with the head space to discharge the process gas.

2. The apparatus according to claim 1, wherein the window consists essentially of a material selected from the group consisting of quartz, silicon oxide, sapphire, and calcium fluoride.

3. The apparatus according to claim 1, wherein the head space and the discharge holes are formed by working on a material that makes the window, and the window is formed by laminating a plurality of plate components that transmit ultraviolet rays.

4. The apparatus according to claim 1, wherein the head space forms a gas passage having a width of 1 to 10 mm on a plane facing the light source.

5. The apparatus according to claim 4, wherein the gas passage forms a lattice pattern.

6. The apparatus according to claim 5, wherein the discharge holes are disposed at corners of the lattice pattern of the gas passage.

7. The apparatus according to claim 4, wherein the gas passage comprises a groove formed in a material that makes the window.

8. The apparatus according to claim 1, wherein the head space forms a gas reservoir having an contour larger than the target substrate.

9. The apparatus according to claim 8, wherein the gas reservoir comprises pin-like support members standing between a top plate and a bottom plate.

10. The apparatus according to claim 9, wherein a ratio of a total planar area of the support members relative to a planar area of the gas reservoir is set at 5 to 30%.

11. The apparatus according to claim 1, further comprising an auxiliary chamber disposed on the process chamber and separated from the process chamber by the window, wherein the light source is disposed in the auxiliary chamber.

12. The apparatus according to claim 1, wherein the process gas comprises a gas for forming a film on the target substrate.

13. The apparatus according to claim 1, wherein the process gas comprises a gas for annealing a film on the target substrate.

14. An ultraviolet-ray-assisted processing apparatus for a semiconductor process, comprising:
a process chamber configured to accommodate a target substrate;
a worktable disposed within the process chamber and configured to support the target substrate;
a heater configured to heat the target substrate through the worktable;
a window disposed in a wall defining the process chamber and to face the worktable, and configured to transmit ultraviolet rays;
a light source disposed outside the process chamber to face the window, and configured to emit ultraviolet rays;
a gas exhaust system configured to exhaust an interior of the process chamber; and
a supply system configured to supply first and second process gases into the process chamber, wherein the supply system includes first and second head spaces formed in the window and which the first and second process gases respectively pass through, and a plurality of first and second discharge holes formed in a surface of the window facing the worktable and respectively communicating with the first and second head spaces to deliver the first and second process gases.

15. The apparatus according to claim 14, wherein the first and second head spaces are stacked in a thickness direction of the window with a dividing plate interposed therebetween.

16. The apparatus according to claim 15, wherein each of the first and second head spaces forms a gas passage having a width of 1 to 10 mm on a plane facing the light source.
